# EUROPEAN PATENT APPLICATION

(11) **EP 4 464 468 A1**
(43) Date of publication of application: **20.11.2024**
(21) Application number: 23846871.4
(22) Date of filing: 10.07.2023
(51) Int. Cl.: B25J 11/00, B25J 13/00, B25J 9/16, B25J 13/08, B25J 19/02

(54) **DIAGNOSTIC ROBOT AND DIAGNOSTIC METHOD THEREFOR**

(30) Priority: 25.07.2022 KR 20220091585
(71) Applicant: SAMSUNG ELECTRONICS CO., LTD., Yeongtong-gu Suwon-si, Gyeonggi-do 16677 (KR)
(72) Inventor: HWANG, Sangyoung, Suwon-si, Gyeonggi-do 16677 (KR); KIM, Woomok, Suwon-si, Gyeonggi-do 16677 (KR); KIM, Jooyoung, Suwon-si, Gyeonggi-do 16677 (KR); MOON, Boseok, Suwon-si, Gyeonggi-do 16677 (KR); SONG, Dongshin, Suwon-si, Gyeonggi-do 16677 (KR); CHOI, Hyunmi, Suwon-si, Gyeonggi-do 16677 (KR)
(74) Representative: Appleyard Lees IP LLP
(86) International application number: PCT/KR2023/009770
(87) International publication number: WO 2024/025212

(57) **Abstract**

Provided is a diagnostic robot including: a communication interface; and at least one processor configured to: control the communication interface to search for at least one candidate electronic device, select a target electronic device from among the at least one candidate electronic device, and identify a component of the target electronic device on which to perform a fault diagnosis, control the communication interface to transmit information associated with a diagnosis range to the target electronic device, obtain first diagnostic data by performing a first fault diagnosis on a component of the diagnostic robot, control the communication interface to receive, from the target electronic device, second diagnostic data generated from a second fault diagnosis performed on the component of the target electronic device while the target electronic device is positioned at a diagnosis area within the diagnosis range, and identify whether there is an abnormality in the component of the target electronic device based on the first diagnostic data and the second diagnostic data.

## Description

### BACKGROUND

### 1. TECHNICAL FIELD

The disclosure relates to a diagnostic robot that diagnoses abnormality in a robot and a diagnostic method thereof.

### 2. BACKGROUND ART

Electronic devices include various electronic components and/or mechanical components. For example, an electronic device may include a robot, a camera, a home appliance, a smartphone, and the like. Further, an electronic component may include a communication interface, an input interface, a processor, a camera, a microphone, a speaker, a display, a memory, a sensor, and the like. A mechanical component may include a driver, an actuator, a wheel, and the like.

### TECHNICAL SOLUTION

According to an aspect of the disclosure, a diagnostic robot includes: a communication interface; and at least one processor configured to: control the communication interface to search for at least one candidate electronic device, select a target electronic device from among the at least one candidate electronic device, and identify a component of the target electronic device on which to perform a fault diagnosis, control the communication interface to transmit information associated with a diagnosis range to the target electronic device, obtain first diagnostic data by performing a first fault diagnosis on a component of the diagnostic robot, control the communication interface to receive, from the target electronic device, second diagnostic data generated from a second fault diagnosis performed on the component of the target electronic device while the target electronic device is positioned at a diagnosis area within the diagnosis range, and identify whether there is an abnormality in the component of the target electronic device based on the first diagnostic data and the second diagnostic data.

The at least one processor of the diagnostic robot may be further configured to: search for the at least one candidate electronic device by receiving data from the at least one candidate electronic device, through the communication interface, information identifying components of the at least one candidate device available for a fault diagnosis and an estimated amount of time to conduct the fault diagnosis.

The at least one processor of the diagnostic robot may be further configured to: select the target electronic device from the at least one candidate electronic device based on the diagnostic robot comprising at least one component corresponding to a component of the at least one candidate electronic device or a priority order identified based on a Jaccard similarity.

The information associated with the diagnosis range may include at least one from among map information, obstacle information, access restricted zone information, position information of the diagnostic robot, direction information of the diagnostic robot, and information of the diagnosis area.

The at least one processor of the diagnostic robot may be further configured to: based on the target electronic device being able to move, transmit, through the communication interface, current position and direction information of the diagnostic robot to the target electronic device to allow the target electronic device to move to the diagnosis area based on the transmitted current position and direction information of the diagnostic robot, and receive, through the communication interface, current position and direction information of the target electronic device.

The at least one processor of the diagnostic robot may be further configured to: based on the target electronic device being unable to move, receive, through the communication interface, current position and direction information of the target electronic device and cause the diagnostic robot to move to the diagnosis area based on the received current position and direction information of the target electronic device, and receive, through the communication interface, current position and direction information of the target electronic device.

The component of the target electronic device may include at least one from among a distance sensor, a camera, a memory, and a processor.

The at least one processor of the diagnostic robot may be further configured to: based on the component of the target electronic device comprising the distance sensor of the target electronic device, cause the diagnostic robot to be a pre-set distance from the target electronic device and to be positioned such that a distance sensor of the diagnostic robot is directed toward the target electronic device and the distance sensor of the target electronic device is directed toward the diagnostic robot, and identify whether there is an abnormality in the distance sensor of the target electronic device by comparing first diagnostic data of the distance sensor of the diagnostic robot with second diagnostic data of the distance sensor of the target electronic device, and wherein the first diagnostic data comprises a distance measurement between the diagnostic robot and the target electronic device taken using the distance sensor of the diagnostic robot, and the second diagnostic data comprises a distance measurement between the diagnostic robot and the target electronic device taken using the distance sensor of the target electronic device.

The at least one processor of the diagnostic robot may be further configured to: based on the component of the target electronic device comprising the camera of the target electronic device, cause the diagnostic robot to be in a position relative to the target electronic device where the camera of the diagnostic robot and the camera of the target electronic device face toward a same direction collinearly, and identify whether there is an abnormality in the camera of the target electronic device by comparing first diagnostic data of the camera of the diagnostic robot and second diagnostic of the camera of the target electronic device, and wherein the first diagnostic data comprises an image captured by the camera of the diagnostic robot and the second diagnostic data comprises an image captured by the camera of the target electronic device.

The at least one processor of the diagnostic robot may be further configured to: based on identifying that there is an abnormality in the component of the target electronic device, cause the communication interface to transmit a stop operation command to the target electronic device or transmit information associated with an abnormality of the target electronic device to a user.

According to an aspect of the disclosure, a diagnostic method of using a diagnostic robot includes: searching for at least one candidate electronic device; selecting a target electronic device from among the at least one candidate electronic device; identifying a component of the target electronic device on which to perform a fault diagnosis; transmitting information associated with a diagnosis range to the target electronic device; obtaining first diagnostic data by performing a first fault diagnosis on a component of the diagnostic robot; receiving, by the diagnostic robot from the target electronic device, second diagnostic data generated from a second fault diagnosis performed on the component of the target electronic device positioned at a diagnosis area within the diagnosis range; and identifying whether there is an abnormality in the component of the target electronic device based on the first diagnostic data and the second diagnostic data.

The searching for the at least one candidate electronic device may include: receiving, by the diagnostic robot, data from the at least one candidate electronic device information identifying components of the at least one candidate electronic device available for a fault diagnosis, and an estimated amount of time to conduct the fault diagnosis.

The selecting the target electronic device may include: selecting the target electronic device from the at least one candidate electronic device based on the diagnostic robot comprising at least one component corresponding to a component of the at least one candidate electronic device or a priority order identified based on a Jaccard similarity.

The information associated with the diagnosis range may include at least one from among map information, obstacle information, access restricted zone information, position information of the diagnostic robot, direction information of the diagnostic robot, information of the diagnosis area.

The diagnostic method may also include: based on the target electronic device being able to move, transmitting current position and direction information of the diagnostic robot to the target electronic device to allow the target electronic device to move to the diagnosis area, and receiving, by the diagnostic robot, current position and direction information of the target electronic device.

### DESCRIPTION OF DRAWINGS

The above and other aspects, features, and advantages of certain embodiments of the present disclosure will be more apparent from the following description taken in conjunction with the accompanying drawings, in which:
FIG.1 is a diagram illustrating a diagnostic robot diagnosing an electronic device according to an embodiment;
FIG. 2 is a block diagram illustrating a configuration of a diagnostic robot according to an embodiment;
FIG. 3 is a block diagram illustrating a detailed configuration of a diagnostic robot according to an embodiment;
FIG. 4 is a diagram illustrating a program stored in a memory according to an embodiment;
FIG. 5 is a diagram illustrating a configuration of a driver according to an embodiment;
FIG. 6A and FIG. 6B are diagrams illustrating a process by which a diagnostic robot and an electronic device are positioned in a diagnostic area according to an embodiment;
FIG. 7A to FIG. 7C are diagrams illustrating a diagnosis process based on a component according to an embodiment;
FIG. 8 is a flowchart illustrating a diagnostic method according to an embodiment; and
FIG. 9 is a timing diagram illustrating a diagnosis process according to an embodiment.

### MODE FOR INVENTION

Various embodiments will be described in greater detail below with reference to the accompanied drawings. Embodiments described herein may be variously modified. A specific embodiment may be illustrated in the drawings and described in detail in the detailed description. However, the specific embodiment described in the accompanied drawing is only to assist in the easy comprehension of the various embodiments. Accordingly, it should be noted that the embodiments of the disclosure are not limited by the specific embodiments described in the accompanied drawings, and should be interpreted to include all modifications, combinations, equivalents and/or alternatives of the embodiments included in the spirit of the disclosure and in the technical scope.

Terms including ordinal numbers such as first and second may be used in describing the various components, but the components are not limited by the above-described terms. The above-described terms may be used only for the purpose of distinguishing one component from another component.

In the disclosure, it is to be understood that the terms such as "comprise" or "include" are used herein to designate a presence of a characteristic, number, step, operation, element, component, or a combination thereof, and not to preclude a presence or a possibility of adding one or more of other characteristics, numbers, steps, operations, elements, components or a combination thereof. When a certain component is indicated as being "coupled with/to" or "connected to" another component, it may be understood as being directly coupled with/to or connected to the another component, but also as other component being present therebetween. On the other hand, when a certain component is indicated as "directly coupled with/to" or "directly connected to" another component, it may be understood as other component not being present therebetween.

The term "module" or "part" for components used in the disclosure may perform at least one function or operation. Further, the "module" or "part" may perform a function or an operation by a hardware, a software, or a combination of hardware and software. In addition, a plurality of "modules," or a plurality of "parts" except for a "module" or a "part" that has to be performed from a specific hardware or is performed in at least one processor may be integrated in at least one module. A singular expression includes a plural expression, unless otherwise specified.

In describing the disclosure, the order of each step is to be understood as nonlimiting unless the order of each step needs to be performed such that a preceding step must be performed logically and temporally prior to a following step. That is, except for exceptional cases as described above, even if a process described as the following step is performed preceding a process described as the preceding step, it does not influence the nature of the disclosure and the scope of protection should also be defined regardless of the order of the step. Further, in the disclosure, expressions such as "A or B" not only refers to any one of A and B selectively, but also may be defined as including both A and B. In addition, the term "include" may have a comprehensive meaning as further including another component in addition to the components listed as included.

In the disclosure, only the essential components necessary in describing the disclosure have been described, and components not related to the nature of the disclosure have been omitted. Further, the disclosure is not to be construed in an exclusive sense including only the recited components, but to be interpreted in a non-exclusive sense where other components may be included.

In addition thereto, in describing the disclosure, in case it is determined that the detailed description of related known technologies or configurations may unnecessarily confuse the gist of the disclosure, the detailed description thereof will be omitted. Each embodiment may be independently implemented or operated, but each embodiment may also be implemented or operated in combination thereof.

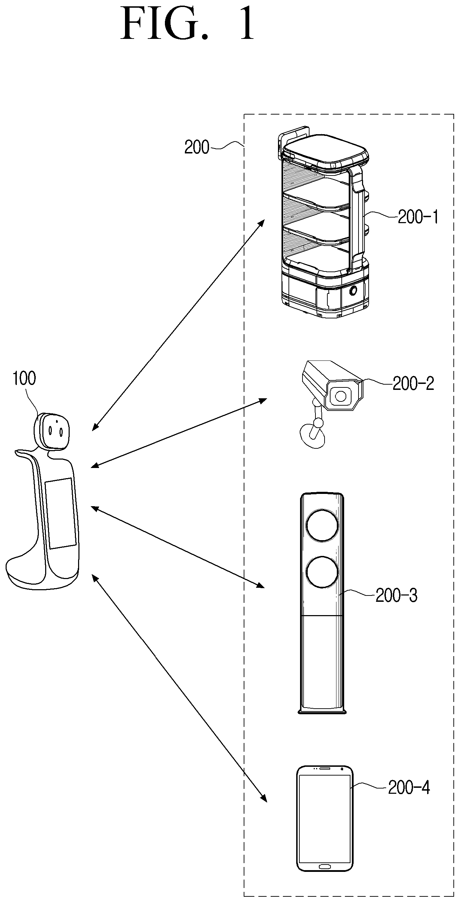

FIG. 1 is a diagram illustrating a diagnostic robot diagnosing an electronic device according to an embodiment.

Referring to FIG. 1, a diagnostic robot 100 and an electronic device 200 are shown. For example, the electronic device 200 may include a robot 200-1, a closed-circuit television (CCTV) 200-2, a home appliance 200-3, a smartphone 200-4, and the like. The electronic device 200 may include not only a device that includes a driver and can move on its own, but also an electronic device that cannot move. The above-described electronic device 200 is merely one embodiment, and is not limited hereto. The electronic device 200 may include various components for performing a function. For example, a component may include an electronic component and/or a mechanical component. In an embodiment, the electronic component may include a communication interface, an input interface, a camera, a microphone, a processor, a speaker, a display, a memory, a sensor, and the like. The mechanical component may include a driver, and the like.

In order for the electronic device 200 to perform a function normally, a component of the electronic device 200 has to operate normally. However, the component of the electronic device 200 may malfunction due to an abnormality being generated. The electronic device 200 performed separate monitoring by disposing same components in plurality to detect a malfunction. However, disposing the same component in plurality complicates a structure of the electronic device 200 and increases cost.

The disclosure simplifies the structure of the electronic device 200 and reduces cost by detecting an abnormality of the electronic device 200 using a diagnostic robot 100.

The diagnostic robot 100 may search for an electronic device for diagnosis by performing communication with the electronic device 200. In an embodiment, the diagnostic robot 100 may transmit diagnosis associated information to a peripheral electronic device 200 with a broadcasting method. The electronic device 200 may transmit, based on determining that a diagnosis is necessary, a diagnosis request signal to the diagnostic robot 100 based on the diagnosis associated information received from the diagnostic robot 100. For example, the diagnosis associated information may include electronic device information, component information for performing a fault diagnosis, and estimated amount of time to conduct the fault diagnosis. That is, the diagnostic robot 100 may transmit the above-described diagnosis associated information to the electronic device 200 with the broadcasting method, and the electronic device 200 may transmit its information associated with the diagnosis and the diagnosis request signal to the diagnostic robot 100.

If the diagnostic robot 100 receives the diagnosis request signal from one electronic device 200, the diagnostic robot 100 may select the electronic device 200 that transmitted the diagnosis request signal as the electronic device for diagnosis. Alternatively, if the diagnostic robot 100 receives the diagnosis request signal from a plurality of electronic devices 200, the diagnostic robot 100 may determine the plurality of electronic devices 200 that transmitted the diagnosis request signal as diagnosis candidate electronic devices. The diagnostic robot 100 may select the electronic device for diagnosis based on the same component or a priority order determined in a pre-set method.

The diagnostic robot 100 may select the electronic device for diagnosis, and may be positioned in a diagnosis area with the electronic device for diagnosis. The diagnosis area may be an area at which the diagnostic robot 100 and the electronic device for diagnosis can perform a smooth communication. The diagnostic robot 100 may transmit information associated with a diagnosis range to the electronic device for diagnosis. For example, the information associated with the diagnosis range may include map information, access restricted zone information, position information of the diagnostic robot 100, direction information of the diagnostic robot 100, diagnosis area information, and the like. The diagnostic robot 100 or the electronic device for diagnosis may be positioned within the diagnosis area based on the information associated with the diagnosis range. For example, if the electronic device for diagnosis is the robot 200-1, the electronic device for diagnosis may move. The electronic device for diagnosis may move to within the diagnosis area with respect to the diagnostic robot 100 based on the information associated with the diagnosis range. If the electronic device for diagnosis is the CCTV 200-2, the home appliance 200-3, or the smartphone 200-4, the electronic device for diagnosis may not move. The diagnostic robot 100 may move to within the diagnosis area with respect to the electronic device for diagnosis based on the information associated with the diagnosis range. The diagnostic robot 100 and the electronic device for diagnosis may respectively transmit and receive current position and direction information until the moving device is positioned within the diagnosis area. The diagnostic robot 100 or the electronic device for diagnosis may move to a diagnosis position within the diagnosis area based on a pre-set standard according to a component to be diagnosed. A detailed description of the diagnosis position will be described below.

If the diagnostic robot 100 and the electronic device for diagnosis are positioned within the diagnosis area, the diagnostic robot 100 may diagnose whether there is an abnormality in the component of the electronic device for diagnosis. For example, if the component to be diagnosed is a distance sensor, the diagnostic robot 100 may obtain first diagnostic data by measuring a distance between electronic device for diagnosis using the distance sensor included in the diagnostic robot 100. Simultaneously or consecutively, the electronic device for diagnosis may obtain second diagnostic data by measuring a distance between the diagnostic robot 100 using the distance sensor included in the electronic device for diagnosis. Alternatively, if the component to be diagnosed is the camera, the diagnostic robot 100 may obtain first diagnostic data by capturing a surrounding environment using the camera included in the diagnostic robot 100. Simultaneously or consecutively, the electronic device for diagnosis may obtain second diagnostic data by capturing the same surrounding environment using the camera included in the electronic device for diagnosis. Alternatively, if the component to be diagnosed is the memory or the processor, the diagnostic robot 100 may obtain first diagnostic data which measured a processing rate, a reading/writing rate, an error ratio, and the like of test data by using the memory or the processor included in the diagnostic robot 100. Simultaneously or consecutively, the electronic device for diagnosis may obtain second diagnostic data which measured the processing rate, the reading/writing rate, the error ratio, and the like of test data by using the memory or the processor included in the electronic device for diagnosis. The electronic device for diagnosis may transmit the obtained second diagnostic data to the diagnostic robot 100.

The diagnostic robot 100 may receive the second diagnostic data and compare with the first diagnostic data. The diagnostic robot 100 may determine, based on identifying a difference greater than or equal to a pre-set ratio or identifying a similarity of less than the pre-set ratio of the first diagnostic data and the second diagnostic data, that the component of the electronic device for diagnosis is in an abnormal state. If the component of the electronic device for diagnosis is determined to be in the abnormal state, the diagnostic robot 100 may transmit a stop operation command of the component to the electronic device for diagnosis. Alternatively, the diagnostic robot 100 may transmit information associated with an abnormality in the component of the electronic device for diagnosis to a user. For example, the diagnostic robot 100 may transmit information associated with the abnormality to a pre-set user device such as a user terminal device and a main control device.

Because the diagnostic robot 100 diagnoses whether there is abnormality in the electronic device, the electronic device may be implemented simply without a diagnosis structure. In addition, the diagnostic robot 100 may diagnose whether there is abnormality for even electronic devices of the related art. Effects of the disclosure are not limited to the effects mentioned above, and other effects that are not mentioned herein may be clearly understood by those of ordinary skill in the art from the description below.

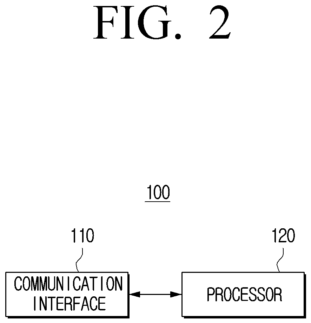

FIG. 2 is a block diagram illustrating a configuration of a diagnostic robot according to an embodiment.

Referring to FIG. 2, the diagnostic robot 100 may include a communication interface 110 and a processor 120.

The communication interface 110 may perform communication with an external device. The communication interface 110 may receive data from the external electronic device, and transmit data of the diagnostic robot 100 to the external electronic device. In an embodiment, the communication interface 110 may transmit a signal searching for the diagnosis candidate electronic devices. The communication interface 110 may transmit a search signal including the diagnosis associated information to search the candidate electronic devices. For example, the diagnosis associated information may include the electronic device information, the component information for performing the fault diagnosis, the estimated amount of time to conduct the fault diagnosis, and the like. The communication interface 110 may broadcast the search signal by using a short-range communication method. Then, the communication interface 110 may receive the diagnosis request signal including the diagnosis associated electronic device information from the external electronic device. If the diagnostic robot 100 selects the electronic device for diagnosis, information associated with the diagnosis range may be transmitted to the electronic device for diagnosis through the communication interface 110. For example, the information associated with the diagnosis range may include the map information, the obstacle information, the access restricted zone information, the position information of the diagnostic robot, the direction information of the diagnostic robot, the diagnosis area information, and the like. In addition, the communication interface 110 may transmit current position and direction information of the diagnostic robot to the electronic device for diagnosis for the diagnostic robot 100 and the electronic device for diagnosis to be positioned at a location within the diagnosis area at which a diagnosis process can be performed. In addition, the communication interface 110 may receive current position and direction information of the electronic device for diagnosis from the electronic device for diagnosis.

When the diagnosis process is performed, the communication interface 110 may transmit a diagnosis associated software to the electronic device for diagnosis, and receive diagnostic data from the electronic device for diagnosis. As a result of diagnosis, if the electronic device for diagnosis is determined as abnormal, the communication interface 110 may transmit the stop operation command to the electronic device for diagnosis or information associated with the abnormality to the user.

For example, the communication interface 110 may perform communication with an external device through at least one communication method from among communication methods of Wi-Fi, Wi-Fi direct, Bluetooth, ZigBee, DLNA, Wide, 3rd Generation (3G), 3rd Generation Partnership Project (3GPP), and Long Term Evolution (LTE). The communication interface 110 may be referred to as a communication device, a communicator, a communication module, a transceiver, and the like.

The processor 120 may control each configuration of the diagnostic robot 100. The processor 120 may control the communication interface 110 to transmit and receive data with the external electronic device.

In addition, the processor 120 may select a target electronic device from among the searched candidate electronic devices, and identify the component of the target electronic device on which to perform the fault diagnosis. For example, if the electronic device that requested the diagnosis is in plurality, the processor 120 may select the target electronic device based on the diagnostic robot 100 and the same component included in the electronic device. Alternatively, the processor 120 may select the target electronic device based on a priority order identified based on a Jaccard Similarity. The component may include the communication interface, the input interface, the camera, the microphone, the speaker, the display, the memory, the sensor, the driver, and the like. If the diagnostic robot 100 and the electronic device for diagnosis are positioned within the diagnosis area at which the diagnosis can be performed, the processor 120 may obtain first diagnostic data by diagnosing a component of the diagnostic robot 100. Further, the processor 120 may compare the obtained first diagnostic data with second diagnostic data received from the electronic device for diagnosis. If a difference between the first diagnostic data and the second diagnostic data is greater than or equal to the pre-set ratio or if a similarity therebetween is less than the pre-set ratio, the processor 120 may determine the component of the electronic device for diagnosis as abnormal. If the component of the target electronic device is determined as abnormal, the processor 120 may control the communication interface 110 to transmit the stop operation command of the component to the electronic device for diagnosis or to transmit the information associated with the abnormality to the user.

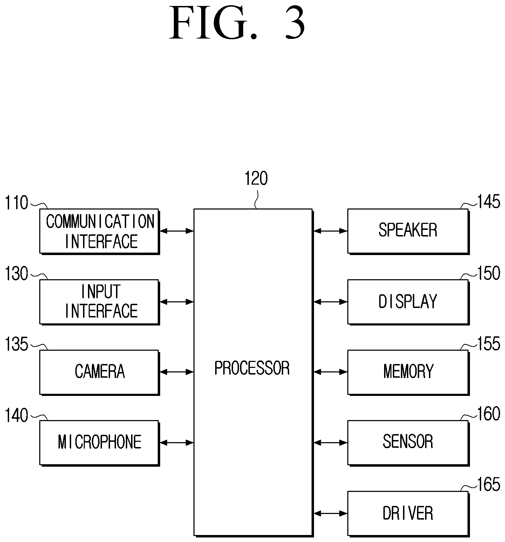

FIG. 3 is a block diagram illustrating a detailed configuration of a diagnostic robot according to an embodiment.

Referring to FIG. 3, the diagnostic robot 100 may include the communication interface 110, the processor 120, an input interface 130, a camera 135, a microphone 140, a speaker 145, a display 150, a memory 155, a sensor 160, and a driver 165. The communication interface 110 and the processor 120 may be similar as that described in FIG. 1.

The input interface 130 may receive input such as a command from the user. The input interface 130 may receive input of a diagnosis process perform command, data or information associated with a diagnosis, and the like. For example, the input interface 130 may include a keyboard, a button, a key pad, a touch pad, a touch screen, and the like. The input interface 130 may be referred to as an input device, an inputter, an input module, and the like.

The camera 135 may capture a surrounding environment of the diagnostic robot 100. The processor 120 may identify an obstacle, an access restricted zone, and the like based on captured surrounding environment. In addition, the processor 120 may generate or update the map information. Alternatively, the camera 135 may capture an expression of the user, a motion, a gaze of the user, and the like. The processor 120 may recognize a control command based on the captured expression of the user, the motion, the gaze of the user, and the like, and perform a control operation corresponding to the recognized control command or the recognized area. For example, the camera 135 may include a charge-coupled device (CCD) sensor and a complementary metal oxide semiconductor (CMOS) sensor. In addition, the camera 135 may also include an RGB camera and a depth camera.

The microphone 140 may receive input of a user voice. The processor 120 may recognize a control command based on the input voice, and perform a control operation corresponding to the recognized control command.

The speaker 145 may output a sound signal performed with a sound signal processing. For example, the speaker 145 may output an input command of the user, information associated with a state of the electronic device 200, motion associated information, notification of whether there is an abnormality in the electronic device for diagnosis, and the like as a voice or a notification sound.

The display 150 may display information in a visual method. For example, the display 150 may display information associated with a diagnosis, a diagnosis result, and the like. For example, the display 150 may be implemented as a Liquid Crystal Display (LCD), an Organic Light Emitting Diode (OLED), a touch screen, and the like. If the display 150 is implemented as a touch screen, the diagnostic robot 100 may receive input of the control command through the touch screen.

The memory 155 may store data or information associated with the diagnosis, software, and the like, and store programs operated in the diagnostic robot 100, commands, and the like. In addition, the memory 155 may store information associated with a map of the current position. Algorithms, data, software, and the like stored in the memory 155 may be loaded to the processor 120 and perform a data processing process by the control of the processor 120. For example, the memory 155 may be implemented in a type such as a read only memory (ROM), a random access memory (RAM), a hard disk drive (HDD), a solid state drive (SSD), memory card, and the like.

The sensor 160 may detect information associated with the user or the surrounding environment. The processor 120 may perform the control operation based on the detected information. In addition, the sensor 160 may perform a sensing operation for a diagnosis for determining whether there is an abnormality in the sensor of the electronic device for diagnosis. For example, the sensor 160 may include a distance sensor, an image sensor, a tracking sensor, an angle sensor, an acceleration sensor, a gravity sensor, a gyro sensor, a geomagnetic sensor, a direction sensor, a motion recognition sensor, a proximity sensor, a voltmeter, an ammeter, a barometer, a hygrometer, a thermometer, a luminance sensor, a heat detection sensor, a touch sensor, an infrared sensor, an ultrasonic sensor, and the like. The distance sensor may be implemented as the ultrasonic sensor, a laser sensor, a light detection and ranging (LiDar) sensor, and the like.

The driver 165 may move the diagnostic robot 100 or perform a pre-set control operation. The driver 165 may operate by the control of the processor 120 based on the stored map information and the detected information. For example, the driver 165 may be implemented in a form of a module that includes a wheel and the like for moving or a robot arm that performs the pre-set control operation, and the like.

The diagnostic robot 100 may include all the configurations described above, or include a portion of the configuration. In addition, the diagnostic robot 100 may further include other configurations that perform various functions in addition to the above-described configurations.

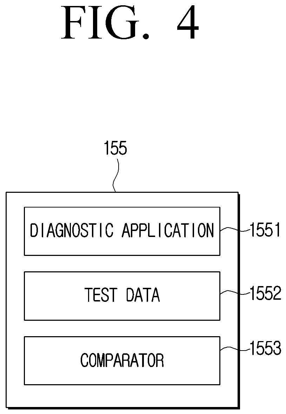

FIG. 4 is a diagram illustrating a program stored in a memory according to an embodiment.

Referring to FIG. 4, the memory 155 may store a diagnostic application (DA) 1551, test data 1552, and a comparator 1553.

The diagnostic application 1551 may be an application that diagnoses a component of a robot for diagnosis. If the diagnostic robot 100 selects the electronic device for diagnosis, the diagnostic application 1551 may be transmitted to the electronic device for diagnosis. The electronic device for diagnosis may install the diagnostic application 1551 received from the diagnostic robot 100. The diagnostic application 1551 installed in the electronic device for diagnosis may perform a diagnosis process of a component of the electronic device for diagnosis.

The test data 1552 may be used in a diagnosis process of a component that processes data. For example, if the component is the memory or the processor, the diagnostic robot 100 may diagnose the component of the electronic device for diagnosis based on the processing rate by which the test data is processed, a rate of a pre-set operation, the reading/writing rate, the error ratio, and the like. In an embodiment, the pre-set operation may include XOR, subtraction (SUB), multiplication (MUL), division (DIV), Bit operation, and the like.

The comparator 1553 may determine whether there is an abnormality by comparing the first diagnostic data obtained by the diagnostic robot 100 and the second diagnostic data received from the electronic device for diagnosis. The processor 120 may determine, based on the difference between the first diagnostic data and the second diagnostic data being greater than or equal to the pre-set ratio or the similarity therebetween being less than the pre-set ratio, that the component of the electronic device for diagnosis is in an abnormal state.

For example, diagnostic robot 100 may diagnose whether there is an abnormality of the processor. The diagnostic robot 100 may transmit the test data 1552 to the electronic device for diagnosis in which the diagnostic application 1551 is installed. Then, the diagnostic robot 100 may process the test data 1552 by using its own processor, and obtain first diagnostic data that includes the processing rate, a Bit operation rate, the reading rate, and the error ratio. Simultaneously or consecutively, the electronic device for diagnosis may also receive the test data 1552, and obtain second diagnostic data that includes the processing rate by which the test data 1552 is processed by using its own processor, the Bit operation rate, the reading rate, and the error ratio. The electronic device for diagnosis may transmit the second diagnostic data to the diagnostic robot 100. The comparator 1553 may compare the first diagnostic data with the second diagnostic data, and the processor 120 may determine whether there is an abnormality in the processor of the electronic device for diagnosis based on the difference or similarity of the first and second diagnostic data.

The diagnostic application (DA) 1551, the test data 1552, and the comparator 1553 stored in the memory 155 may perform the diagnosis process by being loaded to the processor 120 by the control of the processor 120.

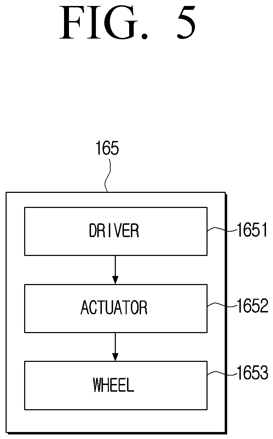

FIG. 5 is a diagram illustrating a configuration of a driver according to an embodiment.

In an embodiment, the diagnostic robot 100 may include a driver in a form of a robot arm, but in FIG. 5, an example of the driver 165 for moving is described. The driver 165 may include a driver 1651, an actuator 1652, and a wheel 1653.

The driver 1651 may control the actuator 1652 based on the control of the processor 120. The driver 1651 may control the actuator 1652 by transmitting an electric signal to the actuator 1652.

The actuator 1652 may control the wheel 1653. For example, the actuator 1652 may include a stepping motor, a DC motor, a linear stage, a linear slide, and the like. The wheel 1653 may rotate by a control of the actuator 1652 and move the diagnostic robot 100.

In the above, a structure of the diagnostic robot 100 has been described. Below, the diagnosis process of the component performed by the diagnostic robot 100 will be described.

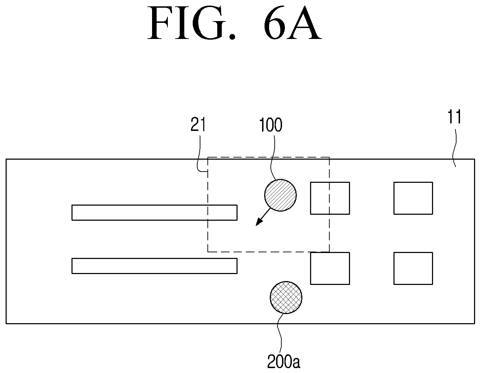

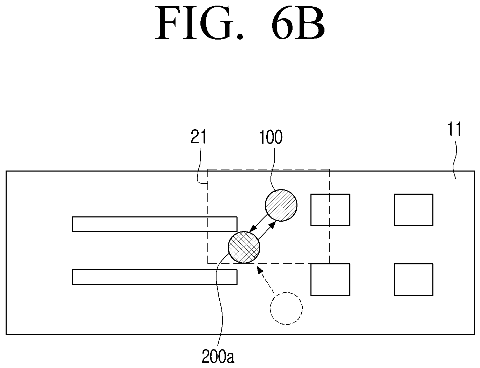

FIG. 6A and FIG. 6B are diagrams illustrating a process by which a diagnostic robot and an electronic device are positioned in a diagnostic area according to an embodiment.

Referring to FIG. 6A and FIG. 6B, the diagnostic robot 100 and an electronic device for diagnosis 200a are shown. The diagnostic robot 100 may include map information 11, and information on a diagnosis range within which a diagnosis can be performed 21. At least one electronic device may be positioned within the surroundings of the diagnostic robot 100.

The diagnostic robot 100 may search for the electronic device for diagnosis by performing communication with the electronic device, and select the electronic device for diagnosis 200a based on the same component included in the diagnostic robot 100 or the priority order determined in the pre-set method. The diagnostic robot 100 may transmit information associated with the diagnosis range to the electronic device for diagnosis 200a. For example, the information associated with the diagnosis range may include the map information, the obstacle information, the access restricted zone information, the position information of the diagnostic robot 100, the direction information of the diagnostic robot 100, the diagnosis area information, and the like.

If moving by the electronic device for diagnosis 200a is possible, the electronic device for diagnosis 200a may move to the diagnosis area for diagnosis. The diagnosis area in the disclosure may include a location for component diagnosis and a diagnosis point at which direction is arranged within the diagnosis range. The diagnostic robot 100 may transmit the current position and direction information of the diagnostic robot 100 to the electronic device for diagnosis 200a until the electronic device for diagnosis 200a is positioned at the diagnosis area. In addition, the electronic device for diagnosis 200a may also transmit the current position and direction information of the electronic device for diagnosis 200a to the diagnostic robot 100.

As shown in FIG. 6B, the electronic device for diagnosis 200a may move to the diagnosis area based on information transmitted to and received from the diagnostic robot 100. As described in the above, the diagnosis area may include a diagnosis point and direction within which the component can be diagnosed. If the electronic device for diagnosis 200a is positioned in the diagnosis area, the diagnostic robot 100 may perform the diagnosis process of the component of the electronic device for diagnosis 200a.

Alternatively, if moving by the electronic device for diagnosis 200a is not possible, the diagnostic robot 100 may move to the diagnosis area for diagnosis. The diagnostic robot 100 may transmit the current position and direction information of the diagnostic robot 100 to the electronic device for diagnosis 200a until the diagnostic robot 100 is positioned at the diagnosis area. In addition, the electronic device for diagnosis 200a may also transmit the current position and direction information of the electronic device for diagnosis 200a to the diagnostic robot 100. The diagnostic robot 100 may move to the diagnosis area based on the information transmitted to and received from the electronic device for diagnosis 200a. If the diagnostic robot 100 is positioned in the diagnosis area, the diagnosis process of the component of the electronic device for diagnosis 200a may be performed.

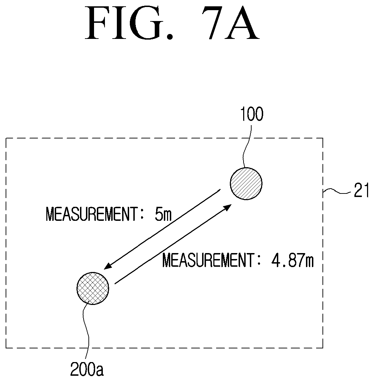

FIG. 7A to FIG. 7C are diagrams illustrating a diagnosis process based on a component according to an embodiment.

In FIG. 7A, a process of diagnosing the distance sensor according to an embodiment is shown. If the component to be diagnosed is the distance sensor, the electronic device for diagnosis 200a (or, the diagnostic robot 100) may be spaced apart from the diagnostic robot 100 (or, the electronic device for diagnosis 200a) by a pre-set distance and positioned at an area facing each other. That is, if the component is the distance sensor, the diagnosis area may be an area at which the electronic device for diagnosis 200a and the diagnostic robot 100 face each other by being spaced apart by a pre-set distance.

The diagnostic robot 100 may transmit a diagnostic application to the electronic device for diagnosis 200a. The electronic device for diagnosis 200a may receive and install the diagnostic application. The diagnostic robot 100 may obtain first diagnostic data that measured the distance with the electronic device for diagnosis 200a using the distance sensor. Simultaneously or consecutively, the electronic device for diagnosis 200a may obtain second diagnostic data that measured the distance with diagnostic robot 100 using the distance sensor. In an embodiment, the diagnostic robot 100 and the electronic device for diagnosis 200a may measure a pre-set plurality of distances. The electronic device for diagnosis 200a may transmit second diagnostic data to the diagnostic robot 100. For example, the second diagnostic data may include information such as an average of measurement values measured a plurality of times, a standard deviation, and the like. Alternatively, the second diagnostic data may include only the measurement value measured a plurality of times, and the diagnostic robot 100 may receive the second diagnostic data that includes only the measurement value and calculate an average of the second diagnostic data, and the standard deviation. The diagnostic robot 100 may compare first diagnostic data and second diagnostic data. The diagnostic robot 100 may determine, based on a comparison result being within a pre-set confidence range, that the distance sensor of the electronic device for diagnosis 200a is normal. Alternatively, the diagnostic robot 100 may determine, based on the comparison result exceeding the pre-set confidence range, that the distance sensor of the electronic device for diagnosis 200a is abnormal.

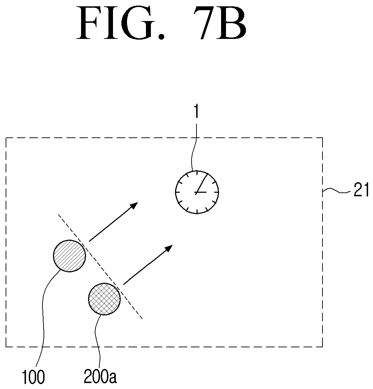

In FIG. 7B, a process of diagnosing the camera according to an embodiment is shown. If the component to be diagnosed is the camera, the electronic device for diagnosis 200a (or, the diagnostic robot 100) may be positioned at an area so as to face toward a same direction collinearly (or, along a same line) with the diagnostic robot 100 (or, the electronic device for diagnosis 200a). That is, if the component is the camera, the diagnosis area may be an area to which the electronic device for diagnosis 200a and the diagnostic robot 100 face toward the same direction collinearly.

The diagnostic robot 100 may obtain first diagnostic data that captured the surrounding environment including an object 1 using the camera. Simultaneously or consecutively, the electronic device for diagnosis 200a may obtain second diagnostic data that captured the surrounding environment including the same object 1 using the camera. The electronic device for diagnosis 200a may transmit the second diagnostic data to the diagnostic robot 100. The diagnostic robot 100 may compare the first diagnostic data and the second diagnostic data. In an embodiment, the diagnostic robot 100 may compare a resolution of diagnostic data, a color value of a pixel, a form of the object 1, a position of the object 1, and the like. The diagnostic robot 100 may determine, based on the comparison result being within the pre-set confidence range, that the camera of the electronic device for diagnosis 200a is normal. Alternatively, the diagnostic robot 100 may determine, based on the comparison result exceeding the pre-set confidence range, that the camera of the electronic device for diagnosis 200a is abnormal.

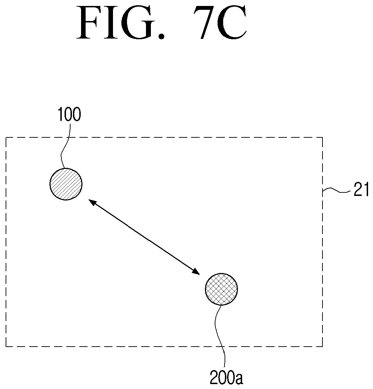

In FIG. 7C, a process of diagnosing the processor or the memory according to an embodiment is shown. If the component to the diagnosed is the processor or the memory, the electronic device for diagnosis 200a (or, the diagnostic robot 100) may be positioned at a random area within a diagnosis range 21 with the diagnostic robot 100 (or, electronic device for diagnosis 200a). That is, if the component is the processor or the memory, the diagnosis area may be a random area within the diagnosis range 21.

The diagnostic robot 100 may transmit the diagnostic application to the electronic device for diagnosis 200a, and the electronic device for diagnosis 200a may install the diagnostic application. Further, the diagnostic robot 100 may transmit test data to the electronic device for diagnosis 200a. The diagnostic robot 100 and the electronic device for diagnosis 200a may respectively obtain the first and second diagnostic data that diagnosed the processor or the memory based on the same test data. For example, if the component is the processor or the memory, the diagnostic data may include the processing rate by which the test data is processed, the rate of the pre-set operation, the reading/writing rate, the error ratio, and the like. The electronic device for diagnosis 200a may transmit the second diagnostic data to the diagnostic robot 100. The diagnostic robot 100 may compare the first diagnostic data and the second measurement. The diagnostic robot 100 may determine, based on the comparison result being within the pre-set confidence range, that the processor or the memory of the electronic device for diagnosis 200a is normal. Alternatively, the diagnostic robot 100 may determine, based on the comparison result exceeding the pre-set confidence range, that the processor or the memory of the electronic device for diagnosis 200a is abnormal.

The diagnostic robot 100 may transmit, based on the diagnosed component being determined as abnormal, the stop operation command to the electronic device for diagnosis 200a or transmit the diagnosis result to the user. In the above, an embodiment of the diagnostic robot 100 performing a diagnosis of a component of the peripheral electronic device has been described. Below, a diagnostic method will be described.

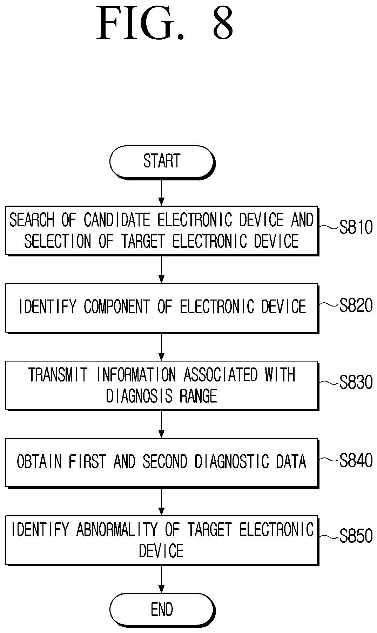

FIG. 8 is a flowchart illustrating a diagnostic method according to an embodiment.

Referring to FIG. 8, the diagnostic robot 100 may search for a candidate electronic device 200 to perform the fault diagnosis, and select a target electronic device 200a from among the candidate electronic devices 200 (S810). For example, the diagnostic robot 100 may receive data including candidate electronic device 200 information, the component information for performing the fault diagnosis, and the estimated amount of time to conduct the fault diagnosis and search the candidate electronic devices 200. Then, the diagnostic robot 100 may select the target electronic device 200a based on the same component included in the candidate electronic devices 200 or the priority order identified based on the Jaccard Similarity.

The diagnostic robot 100 may identify the component of the target electronic device 200a to perform the fault diagnosis (S820). For example, the component may include the distance sensor, the camera, the memory, the processor, and the like.

The diagnostic robot 100 may transmit information associated with the diagnosis range to the target electronic device 200a (S830). For example, the information associated with the diagnosis range may include the map information, the obstacle information, the access restricted zone information, the position information of the diagnostic robot, the direction information of the diagnostic robot, the diagnosis area information, and the like.

The target electronic device 200a may be positioned at the diagnosis area based on the information associated with the diagnosis range. If moving by the target electronic device 200a is possible, the diagnostic robot 100 may transmit the current position and direction information of the diagnostic robot to the target electronic device 200a until the target electronic device 200a is positioned at the diagnosis area, and receive the current position and direction information of the target electronic device. Alternatively, if moving by the target electronic device 200a is not possible, the diagnostic robot 100 may transmit the current position and direction information of the diagnostic robot to the target electronic device 200a until the diagnostic robot 100 is positioned at the diagnosis area, and receive the current position and direction information of the target electronic device.

The diagnosis area in the disclosure may include the diagnosis point and direction with which the component can be diagnosed. For example, if the component to perform the fault diagnosis is the distance sensor, the diagnosis area may be an area at which the diagnostic robot 100 and the target electronic device 200a are spaced apart by the pre-set distance and face each other. If the component to perform the fault diagnosis is the camera, the diagnosis area may be an area to which the diagnostic robot 100 and the target electronic device 200a face toward the same direction collinearly. If the component to perform the fault diagnosis is the processor or the memory, the diagnosis area may be a random area within the diagnosis range.

The diagnostic robot 100 may obtain first diagnostic data by diagnosing the component of the diagnostic robot 100. Then, the diagnostic robot 100 may receive second diagnostic data that diagnosed the component from the target electronic device 200a (S840). The diagnostic robot 100 may identify whether there is an abnormality in the component of the target electronic device 200a by comparing the first diagnostic data with the second diagnostic data.

For example, if the component is the distance sensor, the first diagnostic data may be data of the distance sensor of the diagnostic robot 100 that measured the distance with the target electronic device 200a, and the second diagnostic data may be data of the distance sensor of the target electronic device 200a that measured the distance with the diagnostic robot 100. If the component is the camera, the first diagnostic data may be data of the camera 135 of the diagnostic robot 100 that captured the surrounding environment, and the second diagnostic data may be data of the camera of the target electronic device 200a that captured the surrounding environment. If the component is the processor or the memory, the first diagnostic data may be data that measured the processor or the memory of the diagnostic robot 100, and the second diagnostic data may be data that measured the processor or the memory of the target electronic device 200a.

The diagnostic robot 100 may transmit, based on the component of the target electronic device 200a being identified as abnormal, the stop operation command of the component to the target electronic device 200a. Alternatively, the diagnostic robot 100 may transmit information associated with an abnormality of the target electronic device 200a to the user.

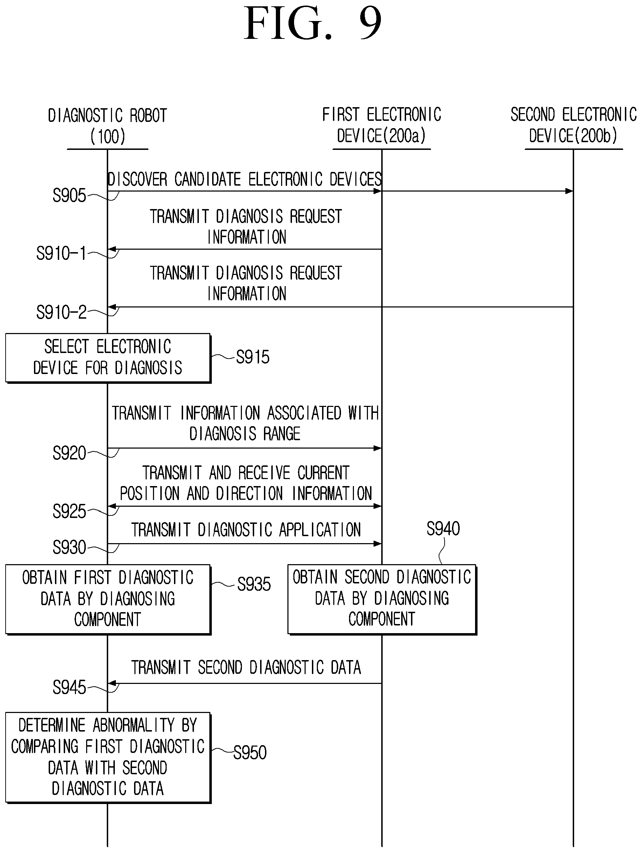

FIG. 9 is a timing diagram illustrating a diagnosis process according to an embodiment.

The diagnostic robot 100 may discover candidate electronic devices 200a and 200b (S905). For example, the diagnostic robot 100 may transmit the diagnosis associated information to peripheral electronic device 200a and 200b in the broadcasting method. The diagnosis associated information may include the electronic device information, the component information for performing the fault diagnosis, and the estimated amount of time to conduct the fault diagnosis.

A first electronic device 200a and a second electronic device 200b may transmit the diagnosis request information to the diagnostic robot 100 (S910-1 and S910-2). The first and second electronic devices 200a and 200b may transmit, based on determining that a diagnosis is necessary, the diagnosis request signal to the diagnostic robot 100 based on the diagnosis associated information received from the diagnostic robot 100.

The diagnostic robot 100 may select the electronic device for diagnosis (S915). For example, the diagnostic robot 100 may select the target electronic device based on the diagnostic robot 100 having the same component included in the first and second electronic devices 200a and 200b. Alternatively, the diagnostic robot 100 may select the target electronic device based on the priority order identified based on the Jaccard similarity. In an embodiment, as shown in FIG. 9, the diagnostic robot 100 may select the first electronic device 200a as the target electronic device.

The diagnostic robot 100 may transmit information associated with the diagnosis range to the first electronic device 200a (S920). For example, the information associated with the diagnosis range may include the map information, the obstacle information, the access restricted zone information, the position information of the diagnostic robot, the direction information of the diagnostic robot, the diagnosis area information, and the like.

The diagnostic robot 100 and the first electronic device 200a may respectively transmit and receive the current position and direction information (S925). The diagnostic robot 100 or the first electronic device 200a may move so as to be positioned at the diagnosis area based on the current position and direction information of each device.

For example, if moving by the first electronic device 200a is possible, the first electronic device 200a may move to the diagnosis area. The diagnostic robot 100 may transmit the current position and direction information of the diagnostic robot to the first electronic device 200a until the first electronic device 200a is positioned at the diagnosis area. In addition, the first electronic device 200a may also transmit the current position and direction information of the first electronic device to the diagnostic robot 100. Alternatively, if moving by the first electronic device 200a is not possible, the diagnostic robot 100 may move to the diagnosis area.

In an embodiment, if the component to perform the fault diagnosis is the distance sensor, the diagnosis area may be an area at which the diagnostic robot 100 and the first electronic device 200a are spaced apart by the pre-set distance and face each other. If the component to perform the fault diagnosis is the camera, the diagnosis area may be an area to which the diagnostic robot 100 and the first electronic device 200a face toward the same direction collinearly. If the component to perform the fault diagnosis is the processor or the memory, the diagnosis area may be a random area within the diagnosis range. If the diagnostic robot 100 or the first electronic device 200a are positioned at the diagnosis area, the diagnostic robot 100 may perform the diagnosis process in the component of the first electronic device 200a.

The diagnostic robot 100 may transmit the diagnostic application to the first electronic device 200a (S930). If the component to be diagnosed is the processor or the memory, the diagnostic robot 100 may transmit test data to the first electronic device 200a. The diagnostic robot 100 may obtain first diagnostic data by diagnosing its own component (S935), and the first electronic device 200a may also obtain second diagnostic data by diagnosing its own component (S940). The first electronic device 200a may transmit the second diagnostic data to the diagnostic robot 100 (S945), and the diagnostic robot 100 may determine whether there is an abnormality by comparing the first diagnostic data with the second diagnostic data (S950). Through the above-described process, the diagnostic robot 100 may diagnose the component of the electronic device that does not include a separate configuration for a diagnosis.

The diagnostic method of the diagnostic robot according to the various embodiments described above may be provided as a computer program product. The computer program product may include a software (S/W) program itself or a non-transitory computer readable medium stored with the S/W program.

The non-transitory computer readable medium may refer to a medium that stores data semi-permanently rather than storing data for a very short time, such as a register, a cache, a memory, or the like, and is readable by a device. Specifically, the above-described various applications or programs may be stored and provided in a non-transitory readable medium such as, for example, and without limitation, a compact disc (CD), a digital versatile disc (DVD), a hard disc, a Blu-ray disc, a USB, a memory card, a ROM, and the like.

While the disclosure has been illustrated and described with reference to various example embodiments thereof, it will be understood that the various example embodiments are intended to be illustrative, not limiting. It will be understood by those skilled in the art that various changes in form and details may be made therein without departing from the true spirit and full scope of the disclosure, including the appended claims and their equivalents.

## Claims

1. A diagnostic robot comprising:
a communication interface; and
at least one processor configured to:
control the communication interface to search for at least one candidate electronic device,
select a target electronic device from among the at least one candidate electronic device, and identify a component of the target electronic device on which to perform a fault diagnosis,
control the communication interface to transmit information associated with a diagnosis range to the target electronic device,
obtain first diagnostic data by performing a first fault diagnosis on a component of the diagnostic robot,
control the communication interface to receive, from the target electronic device, second diagnostic data generated from a second fault diagnosis performed on the component of the target electronic device while the target electronic device is positioned at a diagnosis area within the diagnosis range, and
identify whether there is an abnormality in the component of the target electronic device based on the first diagnostic data and the second diagnostic data.

2. The diagnostic robot of claim 1, wherein the at least one processor is further configured to:
search for the at least one candidate electronic device by receiving data from the at least one candidate electronic device, through the communication interface, information identifying components of the at least one candidate device available for a fault diagnosis and an estimated amount of time to conduct the fault diagnosis.

3. The diagnostic robot of claim 1, wherein the at least one processor is further configured to:
select the target electronic device from the at least one candidate electronic device based on the diagnostic robot comprising at least one component corresponding to a component of the at least one candidate electronic device or a priority order identified based on a Jaccard similarity.

4. The diagnostic robot of claim 1, wherein the information associated with the diagnosis range comprises at least one from among map information, obstacle information, access restricted zone information, position information of the diagnostic robot, direction information of the diagnostic robot, and information of the diagnosis area.

5. The diagnostic robot of claim 1, wherein the at least one processor is further configured to:
based on the target electronic device being able to move, transmit, through the communication interface, current position and direction information of the diagnostic robot to the target electronic device to allow the target electronic device to move to the diagnosis area based on the transmitted current position and direction information of the diagnostic robot, and
receive, through the communication interface, current position and direction information of the target electronic device.

6. The diagnostic robot of claim 1, wherein the at least one processor is further configured to:
based on the target electronic device being unable to move, receive, through the communication interface, current position and direction information of the target electronic device and cause the diagnostic robot to move to the diagnosis area based on the received current position and direction information of the target electronic device, and
receive, through the communication interface, current position and direction information of the target electronic device.

7. The diagnostic robot of claim 1, wherein the component of the target electronic device comprises at least one from among a distance sensor, a camera, a memory, and a processor.

8. The diagnostic robot of claim 7,
wherein the at least one processor is further configured to:
based on the component of the target electronic device comprising the distance sensor of the target electronic device, cause the diagnostic robot to be a pre-set distance from the target electronic device and to be positioned such that a distance sensor of the diagnostic robot is directed toward the target electronic device and the distance sensor of the target electronic device is directed toward the diagnostic robot, and
identify whether there is an abnormality in the distance sensor of the target electronic device by comparing first diagnostic data of the distance sensor of the diagnostic robot with second diagnostic data of the distance sensor of the target electronic device, and
wherein the first diagnostic data comprises a distance measurement between the diagnostic robot and the target electronic device taken using the distance sensor of the diagnostic robot, and the second diagnostic data comprises a distance measurement between the diagnostic robot and the target electronic device taken using the distance sensor of the target electronic device.

9. The diagnostic robot of claim 7, wherein the at least one processor is further configured to:
based on the component of the target electronic device comprising the camera of the target electronic device, cause the diagnostic robot to be in a position relative to the target electronic device where the camera of the diagnostic robot and the camera of the target electronic device face toward a same direction collinearly, and
identify whether there is an abnormality in the camera of the target electronic device by comparing first diagnostic data of the camera of the diagnostic robot and second diagnostic of the camera of the target electronic device, and
wherein the first diagnostic data comprises an image captured by the camera of the diagnostic robot and the second diagnostic data comprises an image captured by the camera of the target electronic device.

10. The diagnostic robot of claim 1, wherein the at least one processor is further configured to:
based on identifying that there is an abnormality in the component of the target electronic device, cause the communication interface to transmit a stop operation command to the target electronic device or transmit information associated with an abnormality of the target electronic device to a user.

11. A diagnostic method of using a diagnostic robot, the method comprising:
searching for at least one candidate electronic device;
selecting a target electronic device from among the at least one candidate electronic device;
identifying a component of the target electronic device on which to perform a fault diagnosis;
transmitting information associated with a diagnosis range to the target electronic device;
obtaining first diagnostic data by performing a first fault diagnosis on a component of the diagnostic robot;
receiving, by the diagnostic robot from the target electronic device, second diagnostic data generated from a second fault diagnosis performed on the component of the target electronic device positioned at a diagnosis area within the diagnosis range; and
identifying whether there is an abnormality in the component of the target electronic device based on the first diagnostic data and the second diagnostic data.

12. The diagnostic method of claim 11, wherein the searching for the at least one candidate electronic device comprises:
receiving, by the diagnostic robot, data from the at least one candidate electronic device information identifying components of the at least one candidate electronic device available for a fault diagnosis, and an estimated amount of time to conduct the fault diagnosis.

13. The diagnostic method of claim 11, wherein the selecting the target electronic device comprises:
selecting the target electronic device from the at least one candidate electronic device based on the diagnostic robot comprising at least one component corresponding to a component of the at least one candidate electronic device or a priority order identified based on a Jaccard similarity.

14. The diagnostic method of claim 11, wherein the information associated with the diagnosis range comprises at least one from among map information, obstacle information, access restricted zone information, position information of the diagnostic robot, direction information of the diagnostic robot, information of the diagnosis area.

15. The diagnostic method of claim 11, further comprising:
based on the target electronic device being able to move, transmitting current position and direction information of the diagnostic robot to the target electronic device to allow the target electronic device to move to the diagnosis area, and
receiving, by the diagnostic robot, current position and direction information of the target electronic device.
